# EUROPEAN PATENT SPECIFICATION

(11) **EP 2 278 707 B1**
(45) Date of publication and mention of the grant of the patent: **18.01.2012**
(21) Application number: 09164564.8
(22) Date of filing: 03.07.2009
(51) Int. Cl.: H03G 5/16

(54) **Dynamic enhancement of audio signals**
Dynamische Verstärkung von Audiosignalen
Amélioration dynamique de signaux audio

(43) Date of publication of application: 26.01.2011
(73) Proprietor: AM3D A/S, 9200 Aalborg SV (DK)
(72) Inventor: Nielsen, Jakob Birkedal, 9000 Aalborg (DK)
(74) Representative: Plougmann & Vingtoft A/S

(56) References cited:
- WO-A-2005/069679
- US-A- 5 672 999
- US-A1- 2009 052 695

## Description

### FIELD OF THE INVENTION

The present invention relates to the field of signal processing, especially audio signal processing. More specifically, the invention provides an audio processor capable of dynamically enhancing an audio input signal. Such audio processor can be used to boost bass and/or treble output from a device with a limited electro-acoustic dynamic range, such as for use in portable communication devices etc.

### BACKGROUND OF THE INVENTION

Compact portable audio devices, such as communication devices in the form of mobile phones, media players, car audio systems and the like include loudspeakers arranged to reproduce an audio signal. However, due to the compact size, such loudspeakers often have a limited maximum acoustic output, especially at low and high frequencies, due to the limited dimensions and due to a limited dynamic range. Altogether, such compact devices have a limited capacity for reproducing music or speech at high levels and still with acceptable sound quality.

A simple linear boost of bass and treble will lead to excessive distortion or even damage of such electro-dynamic systems with a very limited dynamic range. More complicated algorithms are known to provide signal enhancement in a more intelligent manner, however such algorithms are normally not suited for implementing into compact low cost equipment, since powerful digital signal processing power is required to run such algorithm in real-time.

JP 07-221571 discloses a digital tone controller capable of boosting a certain frequency band. A feedback from the signal output of the tone controller is provided to reduce distortion due to clipping. However, still clipping distortion can occur if the full dynamic range is utilized. The reason is that the signal output feedback will not be able to take into account one or a few samples of clipping, because there is a response time between detecting the clipping at the signal output and reducing the level accordingly. Thus, output signal clipping can not be avoided, it can only be reduced down to a limited number of samples.

WO 2005/069679 discloses a bass enhancement algorithm which divides a signal into time segments of a selected frequency range. The time segments are defined by zero crossings. A scaling is then applied to the time segments to obtain a distortion-free bass enhancement.

US 2009/052695 A1 discloses a bass enhancement processor which adds harmonic components generated from an extracted bass signal, so as to virtually enhance the bass level.

US 5,672,999 discloses an audio amplifier avoidance apparatus which identifies signal segments of an audio signal that can have an amplitude peak greater than a particular amplifier clip avoidance threshold. A scaling factor is determined for each signal segment based on the particular threshold, and a modified audio signal is then produced.

### SUMMARY OF THE INVENTION

Thus, according to the above description, it is an object of the present invention to provide a simple processing method or audio processor capable of providing enhancement of one or more specific frequency ranges, such as bass and treble, and the method must be suited for a compact electro-acoustic device with a limited dynamic capability, still without severely affecting sound quality.

In a first aspect, the invention provides an audio processor arranged to receive an audio input signal, such as a digital audio input signal, and generate an enhanced audio output signal in response thereto, the audio processor comprising
- a frequency splitter arranged to split the audio input signal into first and second signal parts representing different frequency bands, such as representing substantially non-overlapping frequency bands,
- a gain calculator arranged
   - to estimate a level of the enhanced audio output signal for a case where the first signal part is multiplied by a previous enhancement gain value, such as the previous enhancement gain value being an enhancement gain applied to the last sample of the audio input signal,
   - to calculate a dynamic headroom available based on the estimated level of the enhanced audio output signal, such as the available dynamic headroom being calculated as a level of full scale subtracted by the level of the enhanced audio output signal, and
   - to calculate an enhancement gain based on the available dynamic headroom,
- a gain unit arranged to apply the enhancement gain to the first signal part to generate an enhanced signal part, and
- a summation unit arranged to generate the enhanced audio output signal by combining, such as summing, the enhanced signal part and the second signal part.

By calculating the dynamic headroom available, preferably for each signal sample, it is possible to determine an enhancement gain, i.e. provide a boost, of e.g. bass and/or treble such that the dynamic headroom is utilized to provide the maximum possible boost. Still, even though providing a high boost effect within the dynamic range, it is possible to avoid or at least significantly reduce clipping of the enhanced output signal, since a previous, preferably last sample, enhancement gain value is used to estimate the output signal level. Thus, since it is possible to predict clipping at the signal output before determining an enhancement gain to be applied to the current signal sample, it is possible to determine an adequately low enhancement gain to avoid output signal clipping. Accordingly, even though significant boost effect can be obtained, it is still possible to obtain a high sound quality. By carefully limiting too fast up and down adjustments of the enhancement gain, but instead focussing on maintaining a fixed enhancement gain most of the time, it is possible to further increase any negative effect on sound quality of the algorithm.

Furthermore, the audio processor according to the first aspect is very easy to implement since only few simple signal processing elements are required, as will be illustrated by means of examples later. Thus, the audio processor is highly suited to enhance bass and/or treble performance of audio equipment with a limited frequency band and a limited dynamic range. Thus, the audio processor can be used to increase audio performance in devices such as mobile phones, TV sets and car audio systems and the like.

In one embodiment, the level of the enhanced audio output signal is estimated by generating a pseudo output signal as a sum of the first signal part multiplied by the previous enhancement gain value and the second signal part. Hereby a simple estimate of the output signal level is provided corresponding to the case where the enhancement gain is maintained equal to the previous enhancement gain, and thus if this results in a dynamic headroom which is below a predetermined threshold, the enhancement gain should be reduced compared to the previous enhancement gain value.

In one embodiment, the enhancement gain is calculated such that substantially all of the available dynamic headroom is utilized to enhance the level of the first signal part. Hereby, a maximum boost effect can be obtained. However, it may alternatively be preferred to calculate an enhancement gain which utilizes up to a predetermined fraction of full scale, such as up to -3 dB or - 6 dB re full scale.

In one embodiment, the gain calculator is arranged to maintain the enhancement gain until the available dynamic headroom is above a predetermined upper threshold or below a predetermined lower threshold. Hereby, rapid fluctuations of the enhancement gain is reduced, and a steady enhancement gain can be maintained until the dynamic headroom becomes too small to ensure an unclipped signal output with such enhancement gain. This ensures a constant high enhancement effect with a minimum of negative sound quality influence.

In one embodiment, rates of up or down adjustment of the enhancement gain compared to a previous enhancement gain value are calculated based on a size of the available dynamic headroom, such as values for the up rate and the down rate being different. By having different up and down rates, it is taken into account that a sudden very small dynamic headroom requires a rapid down adjustment of the enhancement gain to avoid distortion, while the best sound quality is obtained if up adjustments are preformed rather slowly even though the available dynamic headroom would allow an abrupt increase in the enhancement gain without clipping. By taking into account the size of the headroom in the up and down rates, it is possible to take into account the need for a rather quick down adjustment if the headroom is suddenly very small, or even negative. On the other hand, a sudden large dynamic headroom available is preferably followed by a rather slow increase in the enhancement gain.

Preferably, the enhancement gain is calculated to have a value below a predetermined maximum gain value, such as a maximum gain value of +10 dB, such as +20 dB, such as +30 dB. Hereby an unlimited boost effect is avoided, and by making the maximum gain value selectable by the user, it is possible to obtain the desired trade between enhancement effect and minimum negative sound quality influence. Especially, a rate of adjustment of the enhancement gain compared to a previous enhancement gain value may be calculated based on the predetermined maximum gain value, thereby serving to ensure that the aggressiveness of up and down adjustments of the enhancement gain follows the maximum gain value, preferably such that a high maximum gain results in fast time constants for up and down adjustments of the enhancement gain and vice versa.

The gain calculator may be arranged to calculate an enhancement gain being smaller than unity, such as the enhancement gain being calculated to have a value above a predetermined minimum gain value, such as a minimum gain value within the range -10 dB to 0 dB, such as within the range -8 dB to -2 dB, such as within the range -6 dB to -3 dB. Thus, the audio processor may in this way be able to provide a limiting effect, thereby increasing sound quality since the amount of boost effect is reduced.

Preferably, the enhancement gain is calculated for each sample of the input audio signal, and wherein the estimated level of the enhanced audio output signal is calculated based on an enhancement gain applied to the last sample of the first signal part. Hereby it is possible to adjust the enhancement gain for each signal sample and thus provide the best possible control of the enhancement gain making a high enhancement gain possible while still avoiding output signal clipping.

One embodiment can be used for treble enhancement, namely wherein the first signal part represents a frequency band above a limiting frequency, such as 4 above kHz, such as above 6 kHz, such as above 8 kHz, or such as above 10 kHz.

Another embodiment can be used for bass enhancement, namely wherein the first signal part represents a frequency band below a limiting frequency, such as 1 kHz, such as below 500 Hz, such as below 200 Hz, such as below 100 Hz, such as below 80 Hz, or such as below 60 Hz.

It is appreciated that bass and treble enhancement embodiments can be combined into an algorithm for a single processor to provide both bass and treble enhancement.

In some embodiment, the audio processor comprises a saturator arranged to eliminate audible clicks due to signal overflow in the enhanced signal part prior to being combined with the second signal part in the summation unit. Such saturator can be used to further ensure that the full dynamic capability of the system can be used without any annoying signal overflow clicks, and thus maximum enhancement effect can be obtained without any significant reduction of sound quality even though one or a few single output samples may be reduced to full scale value. To further improve sound quality, a filter, such as a low pass or a high pass filter, may be arranged between the saturator and the summation unit.

In a second aspect, the invention provides a device including an audio processor according to the first aspect. Such device may be one of: a mobile phone, a portable computer, a portable media player, a car audio device, and a TV set. As a specific example, it may be possible to save a tweeter in a car audio loudspeaker by providing treble enhancement using the audio processor according to the first aspect, and thus money is saved since the processor for implementing the treble enhancement is already available in the car audio system.

In a third aspect, the invention provides a method for enhancement of an audio input signal, such as a digital audio input signal, the method comprising
- splitting the audio input signal into first and second signal parts representing different frequency bands, such as representing substantially non-overlapping frequency bands,
- estimating a level of the enhanced audio output signal for a case where the first signal part is multiplied by a previous enhancement gain value, such as such the previous enhancement gain value being an enhancement gain applied to the last sample of the first signal part,
- calculating a dynamic headroom available based on the estimated level of the enhanced audio output signal,
- calculating an enhancement gain based on the available dynamic headroom,
- applying the enhancement gain to the first signal part to generate an enhanced signal part, and
- generating the enhanced audio output signal by summing the enhanced signal part and the second signal part.

Such method can be implemented as an algorithm running on a processor taking a digital signal as input and generating a digital signal as output.

In a fourth aspect, the invention provides a computer executable program code arranged to perform the method according to the third aspect. The program code may be dedicated program code for a specific signal processor, or program code arranged for a general purpose computer, e.g. a Personal Computer. The computer executable program code may be stored on a data carrier, such as any type of disk, memory card, memory stick, hard disk etc.

It is appreciated that the same advantages and embodiments described for the first aspect apply as well for the second, third, and fourth aspects. Further, it is appreciated that the described embodiments can be intermixed in any way between all the mentioned aspects.

### BRIEF DESCRIPTION OF THE FIGURES

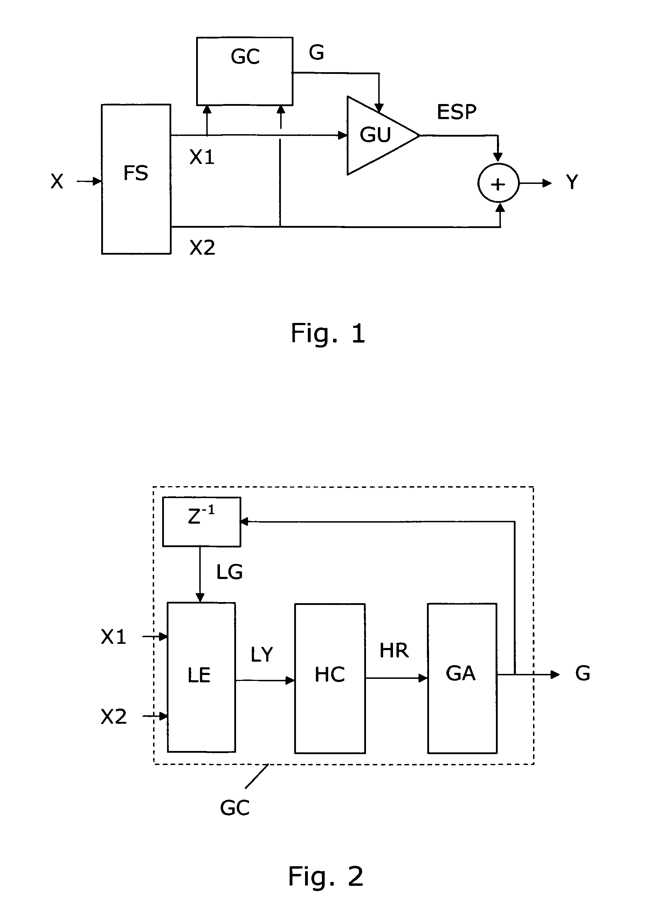

The invention will now be described in more detail with regard to the accompanying figures of which
- Fig.: 1 illustrates a simple block diagram of an audio processor embodiment,
- Fig.: 2 illustrates a block diagram of an example of an enhancement gain calculator
- for the processor embodiment of Fig. 1,
- Fig.: 3 illustrates a block diagram of an example of implementation of a treble enhancement embodiment,
- Fig.: 4 illustrates a block diagram of another treble enhancement embodiment,
- Fig.: 5 illustrates a block diagram of a bass enhancement embodiment,
- Fig.: 6 illustrates a block diagram of a stereo treble enhancement embodiment,
- Fig.: 7 illustrates a device embodiment with a treble enhancement processor, and

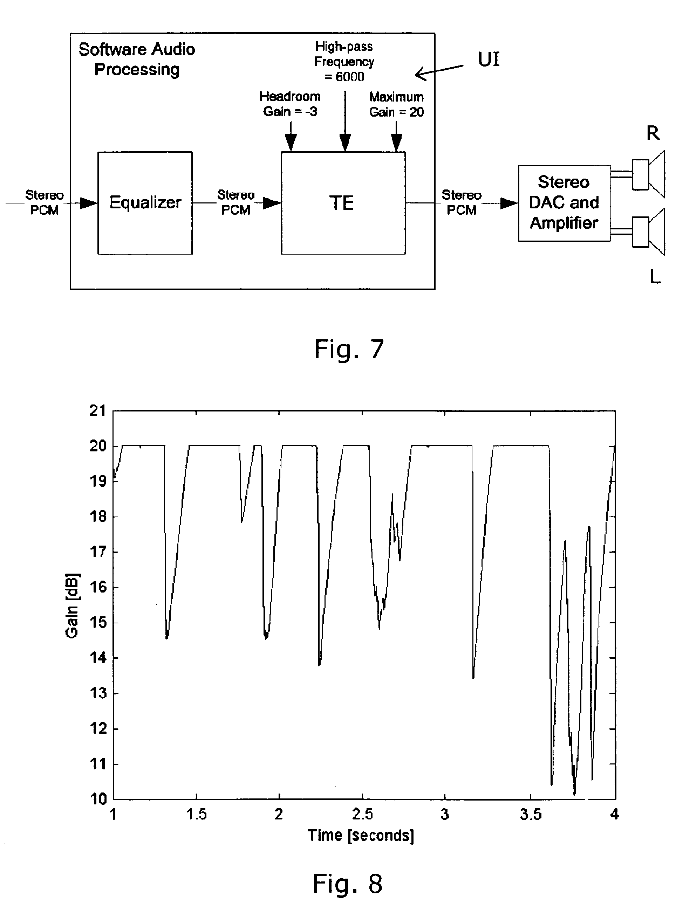

- Fig. 8: illustrates a resulting gain versus time of a treble enhancement embodiment with a maximum enhancement gain setting of 20 dB.

The figures illustrate specific ways of implementing the present invention and are not to be construed as being limiting to other possible embodiments falling within the scope of the attached claim set.

### DETAILED DESCRIPTION OF EMBODIMENTS

In the following, preferred audio processor embodiments are illustrated in block diagram form. It is to be understood that the blocks serve to illustrate functional elements of the audio processor rather than illustrating implementation specific parts of an algorithm suited for efficient execution on a signal processor. Thus, in a practical implementation, some of the illustrated blocks may advantageously be integrated into one single program element, such as the algorithm being rewritten to combine two gain units into one etc.

Fig. 1 illustrates an overall block diagram of an audio processor embodiment receiving an audio input signal X, e.g. in digital form such as a PCM signal. The input signal X is split into two frequency bands in a frequency splitter FS, e.g. by a set of a high pass and a low pass filter, or by appropriate signal manipulation using only one single filter. The resulting two signal parts X1, X2 are then applied to a gain calculator that calculated an enhancement gain G according to a predetermined algorithm. The enhancement gain G is then applied to a gain unit GU that applied this enhancement gain G to the first signal part X1 to produce an enhanced signal part ESP before this enhanced signal part ESP is combined with the second signal part X2 in a summation unit SU, thus resulting in an enhanced audio output signal Y.

The gain calculator GC preferably operates sample-by-sample and is able to calculate a new enhancement gain G for each incoming signal sample. The gain calculator GC estimates a level of the enhanced audio output signal Y based on the assumption that the first signal X1 is multiplied by the same enhancement gain used for gaining the first signal part of last signal sample. This allows the gain calculator to determine a new enhancement gain G prior to actually generating the new sample of the enhanced audio output signal Y. To determine the new enhancement gain G, the gain calculator GC determines a measure of the dynamic headroom available, based on the first and second signal parts X1, X2. Based on the size of the headroom available, a predetermined algorithm adjusts the enhancement gain G to avoid clipping of the output signal and to avoid abrupt changes of the enhancement gain G compared to the enhancement gain used for the last signal sample.

Fig. 2 illustrates a possible functional diagram for the gain calculator GC of Fig. 1. A level estimator LE calculates an estimated level LY of the enhanced audio output signal Y based on the first and second signal parts X1, X2, such as by calculating a pseudo output signal in order to predict the output level LY for the case where the first signal part X1 is multiplied by the last enhancement gain LG, i.e. the enhancement gain applied to the last sample of the first signal sample X1. A headroom calculator HC then calculates the dynamic headroom available HR based on the estimated output level LY. Finally, an enhancement gain algorithm GA is applied with the available dynamic headroom HR as input to determine the new enhancement gain G. This algorithm can be used to maximize enhancement within the given available headroom HR, taking into account a preset maximum gain value e.g. +20 dB, and it may be possible to provide an enhancement gain below 0 dB, such as down to -3 dB, i.e. provide a limiting function. Furthermore, the enhancement gain algorithm GA preferably also takes into account serving to provide a stable enhancement gain G without too many adjustments. This can be implemented by a range of the headroom HR where the enhancement gain G is maintained the same as the last sample enhancement gain LG. Further, time constants are preferably implemented to ensure that up and down adjustments of the enhancement gain are performed rather slowly to avoid audible artefacts.

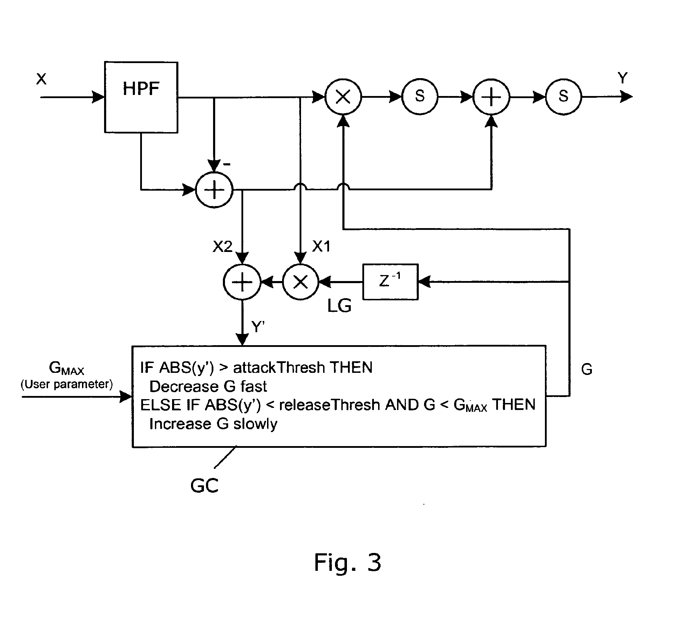

Fig. 3 illustrates a treble enhancement embodiment. The input signal X is first split into first and second signal parts X1, X2 by means of a high pass filter HPF and a summation unit. The first and second signal parts X1, X2 are then combined to generate a pseudo output signal Y'. The first signal part X1 is multiplied by the enhancement gain LG of the last signal sample, and thereafter added to the second signal part X2. In the gain calculator GC the absolute value, i.e. the level, of the pseudo output signal Y' is compared to a headroom threshold 'attackThresh' and if the level of the pseudo output signal Y' exceeds this headroom threshold, the enhancement gain G is decreased in a fast manner compared to the last value. Otherwise, if still below a preset maximum enhancement gain value 'G_{MAX}', then the enhancement gain G is slowly increased. The resulting gain G as output from this algorithm is then multiplied with the first signal part X1, and this enhanced signal part X1 is then added to the non-processed second signal part X2 to produce the enhanced audio output signal Y.

Two saturators S are inserted, one between the enhancement gain unit and the summation unit, and one after the summation unit. These saturators serve to avoid audible clicks due to unintended signal overflow in spite efforts to carefully handle clipping problems in the gain calculator GC. Due to the time constants introduced to provide a rather controlled up and down adjustments of the enhancement gain G, sudden peaks in the input signal may still result in signal overflow.

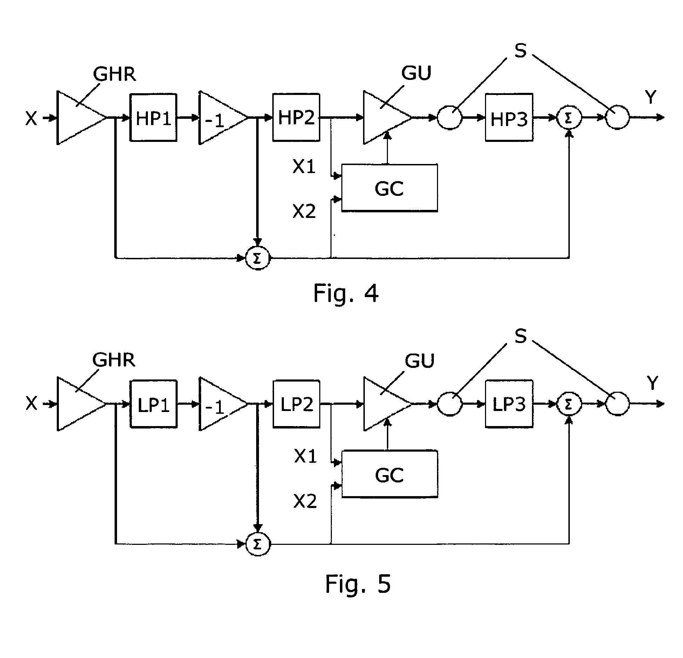

Figs. 4 and 5 illustrate a treble enhancement embodiment and a bass enhancement embodiment, respectively. The difference between the two embodiments is that in the treble enhancement three high pass filters HP1, HP2, HP3 are used, while in the bass enhancement these high pass filters are replaced by low pass filters LP1, LP2, LP3. Apart from this, the configuration of the two embodiments is the same, and thus only a general description of the algorithm will be given.

An initial gain GHR, e.g. -3 dB, is applied to the input signal X to create a dynamic headroom for the signal enhancement. The first filter HP1, LP1 serves together with a summation unit and a -1 gain to split the input signal X into first and second parts X1, X2. A second filter HP2, LP2 is applied to the first signal part X1 before being applied to an enhancement gain calculator GC together with the second signal part X2. This second filter HP2, LP2 serves a dual purpose: to make the frequency splitting more pronounced, and to reduce amplitude distortion. The second filter HP2, LP2 may in a specific embodiment be identical with the first filter HP1, LP1. The third filter HP3, LP3 after the gain unit GU may also be identical with the two other filters. The gain calculator GC function can be such as described already. However, in a specific preferred embodiment for the treble enhancement the gain calculator GC functions according to the following algorithm :

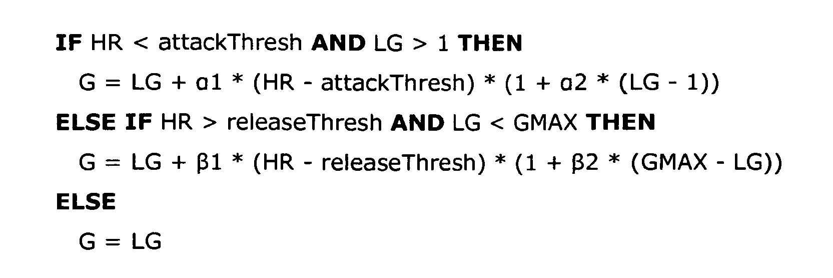

HR is the calculated dynamic headroom available, LG is the enhancement gain for the last signal sample, and thus the algorithm to determine G is run for each signal input sample. GMAX is the predetermined maximum enhancement gain value. The predetermined threshold values attackThresh, and releaseThresh are used to set headroom limits within which the enhancement gain is maintained equal to the value of the previous value, i.e. G = LG. The fixed values α1, α2, β1, β2, are used to provide a scaling of the various factors (HR, attackThresh, releaseThresh, and LG) used to determine the enhancement gain G and the rates of up and down adjustment of the enhancement gain G.

A preferred specific gain calculator GC algorithm for the bass enhancement embodiment is the following:

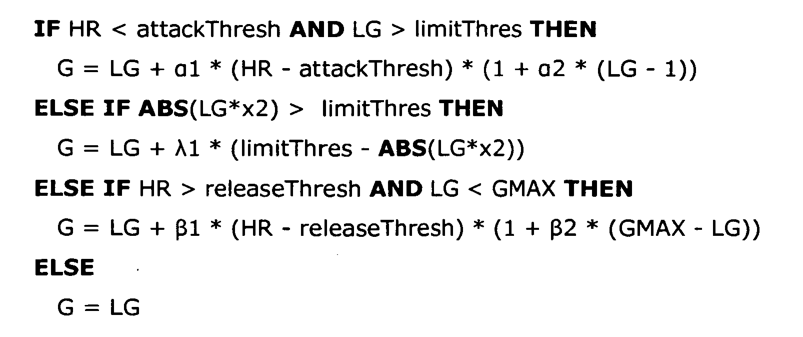

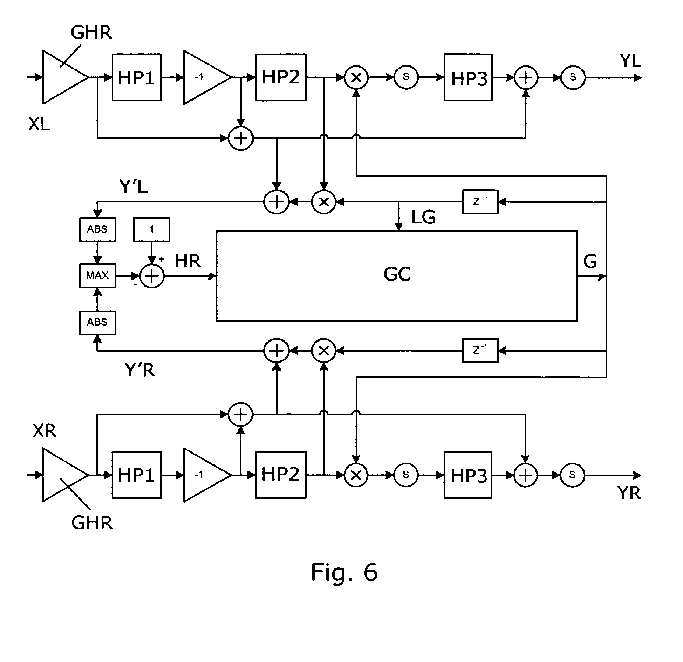

As seen, this algorithm is similar to the above one except for an additional limiting function controlled by further parameters: limitThresh and λ1. Fig. 6 illustrates an example of a treble enhancement in a stereo version, i.e. in a two channel version arranged to perform enhancement on the two input signals XL, XR resulting in respective enhanced output signals YL, YR. As seen, the configuration is similar to previous embodiments such as illustrated in Figs. 3 and 4, apart from the fact that respective pseudo output signals Y'L, Y'R are determined for each input channel. The levels of these signals Y'L, Y'R is determined, illustrated here as taking the absolute value 'ABS' of the signal, and the maximum level of the levels thus determined for the two channels is then used to calculate the dynamic headroom HR, specifically as HR = 1-MAX[ABS(Y'L), ABS(Y'R)]. Hereby one common dynamic headroom HR is calculated for the two channels, namely the smallest one for the two channels, and this is input to the gain calculator GC that calculates one common enhancement gain G for both channels. Thus, the same enhancement gain G is applied to respective first parts of both input channels, thus serving to maintain the stereo balance.

Fig. 7 illustrates an example of a device with a treble enhancement TE algorithm according to the invention implemented in a software audio processing platform. A stereo PCM is first applied to an equalizer, thus applying an equalized stereo PCM signal as input to the treble enhancer TE that generates an enhanced stereo PCM signal in response. This signal is applied to a stereo Digital-to-Analog converter and an amplifier, and finally the respective output electrical signals are reproduced by a set of loudspeakers L, R.

As seen, the treble enhancer TE has three user selectable inputs UI, namely a headroom gain serving to provide a clipping margin, here set to - 3 dB, and a high pass filter cut off frequency, here set to 6 kHz. Finally, a maximum enhancement gain allowed is set to +20 dB. Such user input can be provided via the general user interface of the device, e.g. in the form of a separate sub menu for controlling the enhancement parameters between a number of possible settings.

Fig. 8 illustrates for a full scaled piece of music scaled the realized treble enhancement gain versus time. The frequency split was set to 6 kHz, and the maximum allowed utilization of full scale headroom was set to - 3dB. The maximum enhancement gain was set to +20 dB. As seen, even though the music piece was scaled to utilize the full dynamic range, a significant treble enhancement is obtained, in fact near the maximum +20 dB setting most of the time. Even though the treble gain appears to vary rather much, these variations are masked by the low and mid frequency ranges and the variations are correlated to the rhythm of the music and thus not clearly audible as such.

Thus, with an audio processor according to the invention it is possible to significantly enhance treble and/or bass output from small devices without severe impact on sound quality, and with very simple algorithms that can easily be implemented in compact portable devices with limited processing power.

To sum up: the invention provides an audio processor for generating an audio output signal (Y) with an enhanced spectral component compared to an audio input signal (X). The processor comprises a frequency splitter (FS) for splitting the input (X) into first and second parts (X1, X2) representing different frequency bands. A gain calculator (GC) estimates a level (LY) of the enhanced audio output signal (Y) for a case where the first signal part (X1) is multiplied by a previous enhancement gain value (LG). A dynamic headroom (HR) available is calculated based on the estimated level (LY). An enhancement gain (G) is then calculated based on the available dynamic headroom (HR), and this enhancement gain G is applied to the first signal part (X1), and finally the enhanced output signal (Y) is generate by combining the enhanced signal part (ESP) and the second signal part (X2). Preferably, the enhancement gain G calculation is updated for each signal sample, thus allowing fast adjustments of the gain G to avoid clipping distortion. The audio processor is suited to provide bass and/or treble enhancement and it provides a high utilization of the dynamic range available without audible artefacts. Still, the algorithm is simple to implement and is thus suited for enhancing audio performance of compact low cost devices.

Although the present invention has been described in connection with the specified embodiments, it should not be construed as being in any way limited to the presented examples. The scope of the present invention is to be interpreted in the light of the accompanying claim set. In the context of the claims, the terms "including" or "includes" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. An audio processor arranged to receive an audio input signal (X), and generate an enhanced audio output signal (Y) in response thereto, the audio processor comprising
- a frequency splitter (FS) arranged to split the audio input signal (X) into first and second signal parts (X1, X2) representing different frequency bands,
- a gain calculator (GC) arranged
- to estimate a level (LY) of the enhanced audio output signal (Y) for a case where the first signal part (X1) is multiplied by a previous enhancement gain value (LG),
- to calculate a dynamic headroom (HR) available based on the estimated level (LY) of the enhanced audio output signal (Y), and
- to calculate an enhancement gain (G) based on the available dynamic headroom (HR),
- a gain unit (GU) arranged to apply the enhancement gain (G) to the first signal part (X1) to generate an enhanced signal part (ESP), and
- a summation unit (SU) arranged to generate the enhanced audio output signal (Y) by combining the enhanced signal part (ESP) and the second signal part (X2).

2. Audio processor according to claim 1, wherein the level (LY) of the enhanced audio output signal (Y) is estimated by generating a pseudo output signal (Y') as a sum of the first signal part (X1) multiplied by the previous enhancement gain value (LG) and the second signal part (X2).

3. Audio processor according to claim 1 or 2, wherein the enhancement gain (G) is calculated such that substantially all of the available dynamic headroom (HR) is utilized to enhance the level of the first signal part (X1).

4. Audio processor according to any of the preceding claims, wherein the gain calculator (GC) is arranged to maintain the enhancement gain (G) until the available dynamic headroom (HR) is above a predetermined upper threshold or below a predetermined lower threshold.

5. Audio processor according to any of the preceding claims, wherein rates of up or down adjustment of the enhancement gain (G) compared to a previous enhancement gain value (LG) are calculated based on a size of the available dynamic headroom (HR).

6. Audio processor according to any of the preceding claims, wherein the enhancement gain (G) is calculated to have a value below a predetermined maximum gain value.

7. Audio processor according to any of the preceding claims, wherein the gain calculator (GC) is arranged to calculate an enhancement gain (G) being smaller than unity.

8. Audio processor according to any of the preceding claims, wherein the enhancement gain (G) is calculated for each sample of the input audio signal (X), and wherein the estimated level (LY) of the enhanced audio output signal (Y) is calculated based on an enhancement gain (LG) applied to the last sample of the first signal part (X1).

9. Audio processor according to any of the preceding claims, wherein the first signal part (X1) represents a frequency band above a limiting frequency.

10. Audio processor according to any of the preceding claims, wherein the first signal part (X1) represents a frequency band below a limiting frequency.

11. Audio processor according to any of the preceding claims, comprising a saturator (S) arranged to eliminate audible clicks due to signal overflow in the enhanced signal part (ESP) prior to being combined with the second signal part in the summation unit (SU).

12. Audio processor according to claim 11, comprising a filter arranged between the saturator (S) and the summation unit (SU).

13. A device (DEV) including an audio processor (AP) according to any of claims 1-12.

14. A method for enhancement of an audio input signal (X), the method comprising
- splitting the audio input signal (X) into first and second signal parts (X1, X2) representing different frequency bands,
- estimating a level (LY) of the enhanced audio output signal (Y) for a case where the first signal part (X1) is multiplied by a previous enhancement gain value (LG),
- calculating a dynamic headroom (HR) available based on the estimated level (LY) of the enhanced audio output signal (Y),
- calculating an enhancement gain (G) based on the available dynamic headroom (HR),
- applying the enhancement gain (G) to the first signal part (X1) to generate an enhanced signal part (ESP), and
- generating the enhanced audio output signal (Y) by summing the enhanced signal part (ESP) and the second signal part (X2).

15. Computer executable program code arranged to perform the method according to claim 14.

## Patentansprüche

1. Audioprozessor, vorgesehen zum Empfangen eines Audio-Eingangssignals (X) und als Antwort darauf zum Erzeugen eines angehobenen Audio-Ausgangssignals, wobei der Audioprozessor umfasst
- eine Frequenzweiche (FS), die dazu vorgesehen ist, dass Audio-Eingangssignal (X) in einen ersten und zweiten Signalteil (X1, X2) zu trennen, die unterschiedliche Frequenzbänder repräsentieren,
- einen Verstärkungsrechner (GC), vorgesehen zum
- Schätzen eines Pegels (LY) des angehobenen Audio-Ausgangssignals (Y) für den Fall, dass der erste Signalteil (X1) mit einem vorherigen Anhebungsverstärkungswert (LG) multipliziert ist,
- Berechnen einer dynamischen Übersteuerungsreserve (HR), die auf der Grundlage des geschätzten Pegels (LY) des angehobenen Audio-Ausgangssignals (Y) verfügbar ist, und
- Berechnen einer Anhebungsverstärkung (G) auf der Grundlage der verfügbaren dynamischen Übersteuerungsreserve (HR),
- eine Verstärkungseinheit (GU), die dazu vorgesehen ist, zum Erzeugen eines angehobenen Signalteils (ESP) die Anhebungsverstärkung (G) am ersten Signalteil (X1) anzulegen, und
- eine Summiereinheit (SU), die dazu vorgesehen ist, durch Vereinigen des angehobenen Signalteils (ESP) und des zweiten Signalteils (X2) das angehobene Audio-Ausgangssignal (Y) zu erzeugen.

2. Audioprozessor nach Anspruch 1, wobei der Pegel (LY) des angehobenen Audio-Ausgangssignals (Y) durch Erzeugen eines Pseudo-Ausgangssignals (Y') als Summe des ersten Signalteils (X1) multipliziert mit dem vorherigen Anhebungsverstärkungswert (LG) und dem zweiten Signalteil (X2) geschätzt wird.

3. Audioprozessor nach Anspruch 1 oder 2, wobei die Anhebungsverstärkung (G) derart berechnet wird, dass im Wesentlichen die gesamte verfügbare dynamische Übersteuerungsreserve (HR) zur Anhebung des Pegels des ersten Signalteils (X1) verwendet wird.

4. Audioprozessor nach einem der vorhergehenden Ansprüche, wobei der Verstärkungsrechner (GC) dazu vorgesehen ist, die Anhebungsverstärkung (G) zu halten, bis die verfügbare dynamische Übersteuerungsreserve (HR) über einer vorbestimmten oberen Schwelle oder unter einer vorbestimmten unteren Schwelle ist.

5. Audioprozessor nach einem der vorhergehenden Ansprüche, wobei die Raten einer Einstellung der Anhebungsverstärkung (G) nach oben oder unten verglichen mit einem vorherigen Anhebungsverstärkungswert (LG) auf der Grundlage einer Größe der verfügbaren dynamischen Übersteuerungsreserve (HR) berechnet werden.

6. Audioprozessor nach einem der vorhergehenden Ansprüche, wobei die Anhebungsverstärkung (G) mit einem Wert unterhalb eines vorbestimmten maximalen Verstärkungswerts berechnet wird.

7. Audioprozessor nach einem der vorhergehenden Ansprüche, wobei der Verstärkungsrechner (GC) dazu vorgesehen ist, eine Anhebungsverstärkung (G) kleiner als Eins zu berechnen.

8. Audioprozessor nach einem der vorhergehenden Ansprüche, wobei die Anhebungsverstärkung (G) für jede Probe des Audio-Eingangssignals (X) berechnet wird und wobei der geschätzte Pegel (LY) des angehobenen Audio-Ausgangssignals (Y) auf der Grundlage einer Anhebungsverstärkung (LG) berechnet wird, die an der letzten Probe des ersten Signalteils (X1) angelegt wurde.

9. Audioprozessor nach einem der vorhergehenden Ansprüche, wobei der erste Signalteil (X1) ein Frequenzband über einer Grenzfrequenz repräsentiert.

10. Audioprozessor nach einem der vorhergehenden Ansprüche, wobei der erste Signalteil (X1) ein Frequenzband unter einer Grenzfrequenz repräsentiert.

11. Audioprozessor nach einem der vorhergehenden Ansprüche, umfassend einen Sättiger (S), der dazu vorgesehen ist, hörbare Klicks aufgrund von Signalüberlauf in dem angehobenen Signalteil (ESP) vor der Kombination mit dem zweiten Signalteil in der Summiereinheit (SU) auszulöschen.

12. Audioprozessor nach Anspruch 11, umfassend ein Filter, das zwischen dem Sättiger (S) und der Summiereinheit (SU) angeordnet ist.

13. Vorrichtung (DEV) umfassend einen Audioprozessor (AP) nach einem der Ansprüche 1-12.

14. Verfahren zum Anheben eines Audio-Eingangssignals (X), wobei das Verfahren umfasst
- Trennen des Audio-Eingangssignals (X) in einen ersten und zweiten Signalteil (X1, X2), die unterschiedliche Frequenzbänder repräsentieren,
- Schätzen eines Pegels (LY) des angehobenen Audio-Ausgangssignals (Y) für den Fall, dass der erste Signalteil (X1) mit einem vorherigen Anhebungsverstärkungswert (LG) multipliziert ist,
- Berechnen einer dynamischen Übersteuerungsreserve (HR), die auf der Grundlage des geschätzten Pegels (LY) des angehobenen Audio-Ausgangssignals (Y) verfügbar ist,
- Berechnen einer Anhebungsverstärkung (G) auf der Grundlage der verfügbaren dynamischen Übersteuerungsreserve (HR),
- Anlegen der Anhebungsverstärkung (G) am ersten Signalteil (X1) zum Erzeugen eines angehobenen Signalteils (ESP), und
- Erzeugen des angehobenen Audio-Ausgangssignals (Y) durch Vereinigen des angehobenen Signalteils (ESP) und des zweiten Signalteils (X2).

15. Von einem Computer ausführbarer Programmcode, der dazu vorgesehen ist, das Verfahren nach Anspruch 14 durchzuführen.

## Revendications

1. Processeur audio conçu pour recevoir un signal d'entrée audio (X) et générer un signal de sortie audio amélioré (Y) en réponse à celui-ci, le processeur audio comprenant
- un diviseur de fréquence (FS) conçu pour diviser le signal d'entrée audio (X) en une première et une deuxième partie de signal (X1, X2) représentant différentes bandes de fréquences,
- un calculateur de gain (GC) conçu pour
- estimer un niveau (LY) du signal de sortie audio amélioré (Y) dans un cas où la première partie de signal (X1) est multipliée par une valeur de gain d'amélioration (LG) antérieure,
- calculer une marge dynamique (HR) disponible sur la base du niveau (LY) estimé du signal de sortie audio amélioré (Y), et
- calculer un gain d'amélioration (G) sur la base de la marge dynamique (HR) disponible,
- une unité de gain (GU) conçue pour appliquer le gain d'amélioration (G) à la première partie de signal (X1) afin de générer une partie de signal améliorée (ESP), et
- une unité de sommation (SU) conçue pour générer le signal de sortie audio amélioré (Y) en combinant la partie de signal améliorée (ESP) et la deuxième partie de signal (X2).

2. Processeur audio selon la revendication 1, dans lequel le niveau (LY) du signal de sortie audio amélioré (Y) est estimé en générant un pseudo-signal de sortie (Y') étant une somme de la première partie de signal (X1) multipliée par la valeur de gain d'amélioration (LG) antérieure et de la deuxième partie de signal (X2).

3. Processeur audio selon la revendication 1 ou 2, dans lequel le gain d'amélioration (G) est calculé de manière à ce que la quasi-totalité de la marge dynamique (HR) disponible soit utilisée pour améliorer le niveau de la première partie de signal (X1).

4. Processeur audio selon l'une quelconque des revendications précédentes, dans lequel le calculateur de gain (GC) est conçu pour maintenir le gain d'amélioration (G) jusqu'à ce que la marge dynamique (HR) disponible soit supérieure à un seuil haut prédéterminé ou inférieure à un seuil bas prédéterminé.

5. Processeur audio selon l'une quelconque des revendications précédentes, dans lequel les taux d'ajustement vers le haut ou vers le bas du gain d'amélioration (G) par comparaison à une valeur de gain d'amélioration (LG) antérieure sont calculés sur la base d'une taille de la marge dynamique (HR) disponible.

6. Processeur audio selon l'une quelconque des revendications précédentes, dans lequel le gain d'amélioration (G) est calculé pour que sa valeur soit inférieure à une valeur de gain maximum prédéterminée.

7. Processeur audio selon l'une quelconque des revendications précédentes, dans lequel le calculateur de gain (GC) est conçu pour calculer un gain d'amélioration (G) inférieur à l'unité.

8. Processeur audio selon l'une quelconque des revendications précédentes, dans lequel le gain d'amélioration (G) est calculé pour chaque échantillon du signal d'entrée audio (X), et dans lequel le niveau (LY) estimé du signal de sortie audio amélioré (Y) est calculé sur la base d'un gain d'amélioration (LG) appliqué au dernier échantillon de la première partie de signal (X1).

9. Processeur audio selon l'une quelconque des revendications précédentes, dans lequel la première partie de signal (X1) représente une bande de fréquences supérieure à une fréquence limite.

10. Processeur audio selon l'une quelconque des revendications précédentes, dans lequel la première partie de signal (X1) représente une bande de fréquences inférieure à une fréquence limite.

11. Processeur audio selon l'une quelconque des revendications précédentes, comprenant un saturateur (S) conçu pour éliminer des claquements audibles dus au débordement du signal dans la partie de signal améliorée (ESP) avant qu'il soit combiné à la deuxième partie de signal dans l'unité de sommation (SU).

12. Processeur audio selon la revendication 11, comprenant un filtre disposé entre le saturateur (S) et l'unité de sommation (SU).

13. Dispositif (DEV) comprenant un processeur audio (AP) selon l'une quelconque des revendications 1 à 12.

14. Méthode d'amélioration d'un signal d'entrée audio (X), la méthode comprenant
- division du signal d'entrée audio (X) en une première et une deuxième partie de signal (X1, X2) représentant différentes bandes de fréquences,
- estimation d'un niveau (LY) du signal de sortie audio amélioré (Y) dans un cas où la première partie de signal (X1) est multipliée par une valeur de gain d'amélioration (LG) antérieure,
- calcul d'une marge dynamique (HR) disponible sur la base du niveau (LY) estimé du signal de sortie audio amélioré (Y), et
- calcul d'un gain d'amélioration (G) sur la base de la marge dynamique (HR) disponible,
- application du gain d'amélioration (G) à la première partie de signal (X1) afin de générer une partie de signal améliorée (ESP), et
- génération du signal de sortie audio amélioré (Y) en faisant la somme de la partie de signal améliorée (ESP) et de la deuxième partie de signal (X2).

15. Code programme exécutable par un ordinateur conçu pour mettre en oeuvre la méthode selon la revendication 14.
